# EUROPEAN PATENT SPECIFICATION

(11) **EP 3 091 275 B1**
(45) Date of publication and mention of the grant of the patent: **14.02.2018**
(21) Application number: 16162243.6
(22) Date of filing: 24.03.2016
(51) Int. Cl.: F21V 19/00, F21V 23/06, H01L 33/62, F21V 3/04, F21V 17/04, F21Y 115/10, H01L 33/64

(54) **A METHOD OF ASSEMBLING LIGHTING DEVICES AND CORRESPONDING DEVICE**
VERFAHREN ZUR MONTAGE VON BELEUCHTUNGSEINRICHTUNGEN SOWIE ENTSPRECHENDE VORRICHTUNG
PROCÉDÉ D'ASSEMBLAGE DE DISPOSITIFS D'ÉCLAIRAGE ET DISPOSITIF CORRESPONDANT

(30) Priority: 08.05.2015 IT UB20150274
(43) Date of publication of application: 09.11.2016
(73) Proprietor: OSRAM GmbH, 80807 München (DE); OSRAM S.P.A. - SOCIETA' RIUNITE OSRAM EDISON CLERICI, 20126 Milano (IT)
(72) Inventor: ESPOSITO, Fabio, I-35010 Vigonza (Padova) (IT); ALFIER, Alberto, I-31050 Vedelago (Treviso) (IT); NIEDERMEIER, Peter, D-80995 München (DE)
(74) Representative: Bosotti, Luciano

(56) References cited:
- WO-A1-2009/025078
- WO-A1-2015/022740
- US-A1- 2002 113 244
- US-A1- 2007 058 378
- US-A1- 2007 098 334
- US-A1- 2010 164 346
- US-A1- 2012 294 012

## Description

### Technical Field

The present description relates to lighting devices.

One or more embodiments may refer to lighting devices employing, as light radiation sources, solid-state sources, e.g. LED sources.

### Technological Background

For the assembling of solid-state lighting devices, e.g. LED lighting devices, boards comparable to Printed Circuit Boards (PCBs) are widely used, whereon the light radiation sources are assembled via a soldering process.

In this way it is possible to achieve an electrical, a mechanical as well as a thermal connection.

Despite its widespread use, this solution may be unsatisfactory in various applications, e.g. for assembling solid-state light radiation sources in the automotive sector, for example for retrofit applications.

In this respect the use has been proposed of frame-like structures, adapted to perform an electrical and mechanical connection, e.g. of a LED, without the need to resort to a soldering operation on a PCB.

This approach, however, leads to critical aspects as regards both design and implementation, e.g. concerning the protection of semiconductor chips from external agents (e.g. humidity, ESD discharge) and/or during the assembling process (e.g. as regards the execution of so-called "pick & place" functions).

More specifically, the invention relates to a method of assembling lighting devices according to the preamble of claim 1, which is known, e.g. from WO 2009/025078A1. Somewhat similar arrangements are known e.g. from WO 2015/022740A1 or US 2012/294012A1. Also US 2007/098334A1, US 2010/164346A1, US 2002/113244A1 and US 2007/058378A1 are of interest for the invention.

### Object and Summary

One or more embodiments aim at overcoming the previously outlined drawbacks.

According to one or more embodiments, said object is achieved thanks to a method having the features set forth in claim 1 that follows.

One or more embodiments may also concern a corresponding lighting device according to claim 6.

The claims are an integral part of the technical teaching provided herein with reference to the embodiments.

One or more embodiments enable to achieve the mechanical assembling of a solid-state light radiation source, e.g. a LED source, while avoiding soldering processes, e.g. on PCBs. Moreover, the opportunity is given to extend the previously described advantage to the implementation of electrical and/or thermal contacts as well.

### Brief Description of the Figures

One or more embodiments will now be described, by way of non-limiting example only, with reference to the annexed Figures, wherein:
- Figure 1 and Figure 2 are two views, from approximately mutually opposite viewpoints, of a light radiation source adapted to be used in one or more embodiments;
- Figures 3 and 4 show two components of embodiments;
- Figures 5 to 10 show various steps of a possible assembling sequence according to one or more embodiments.

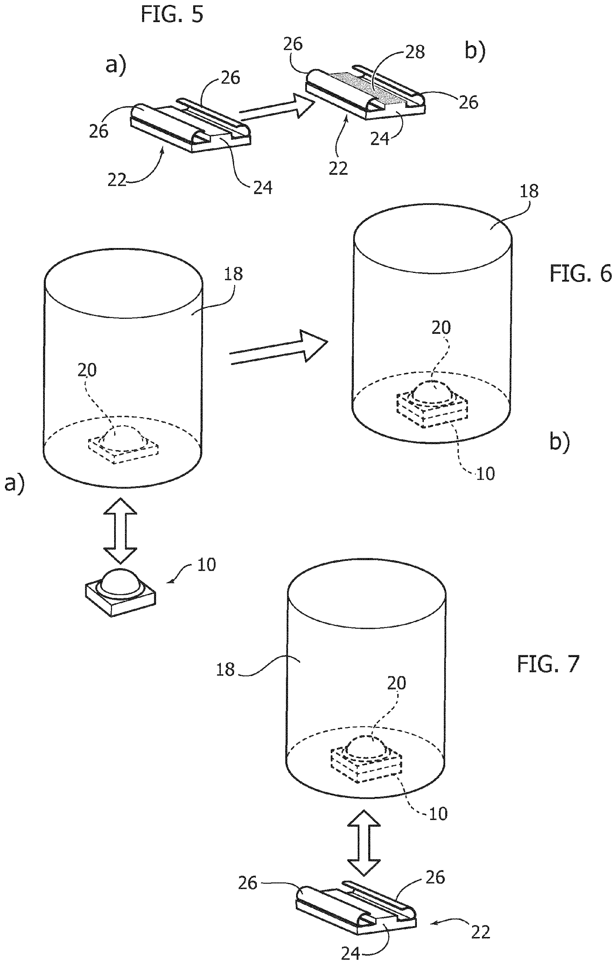

Figures 5, 6 and 8 each include two parts, respectively denoted as a) and b).

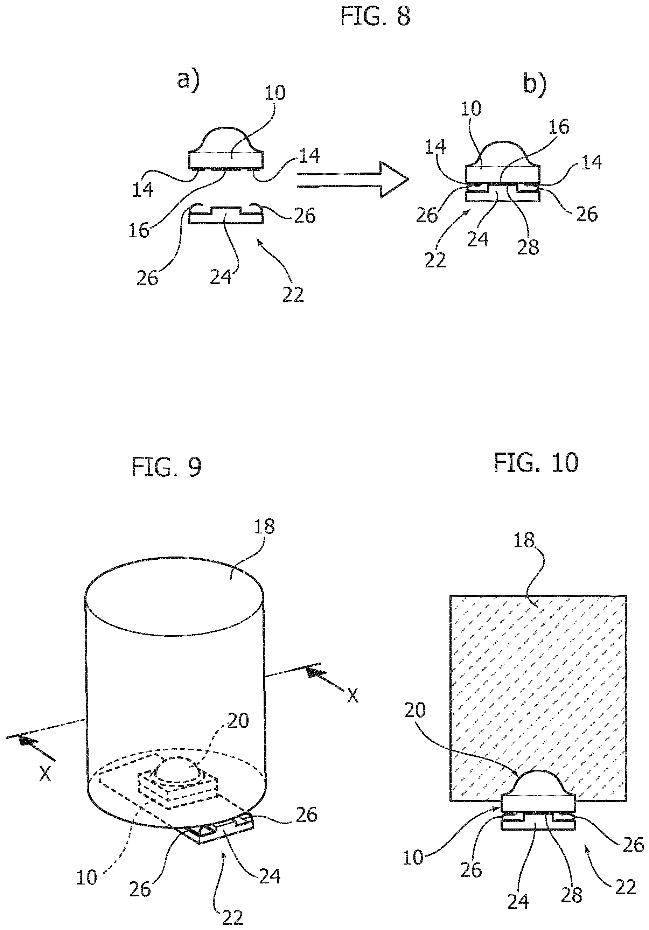

Figure 10 substantially corresponds to a section along line X-X of Figure 9.

It will be appreciated that, for better clarity of illustration, the parts visible in the Figures are not to be considered necessarily drawn to scale.

### Detailed Description

In the following description, numerous specific details are given to provide a thorough understanding of one or more embodiments. The embodiments may be practiced without one or several specific details, or with other methods, components, materials, etc. In other instances, well-known structures, materials, or operations are not shown or described in detail to avoid obscuring various aspects of the embodiments. Reference throughout this specification to "one embodiment" or "an embodiment" means that a particular feature, structure, or characteristic described in connection with the embodiment is included in at least one embodiment. Thus, the possible appearances of the phrases "in one embodiment" or "in an embodiment" in various places throughout this specification are not necessarily all referring to the same embodiment. Furthermore, particular features, structures, or characteristics may be combined in any suitable manner in one or more embodiments, and/or may be associated to the embodiments in a different way from what is shown herein, so that e.g. a feature herein exemplified in connection to a Figure may be applied to one or more embodiments exemplified in a different Figure.

The headings provided herein are for convenience only, and therefore do not interpret the extent of protection or meaning of the embodiments.

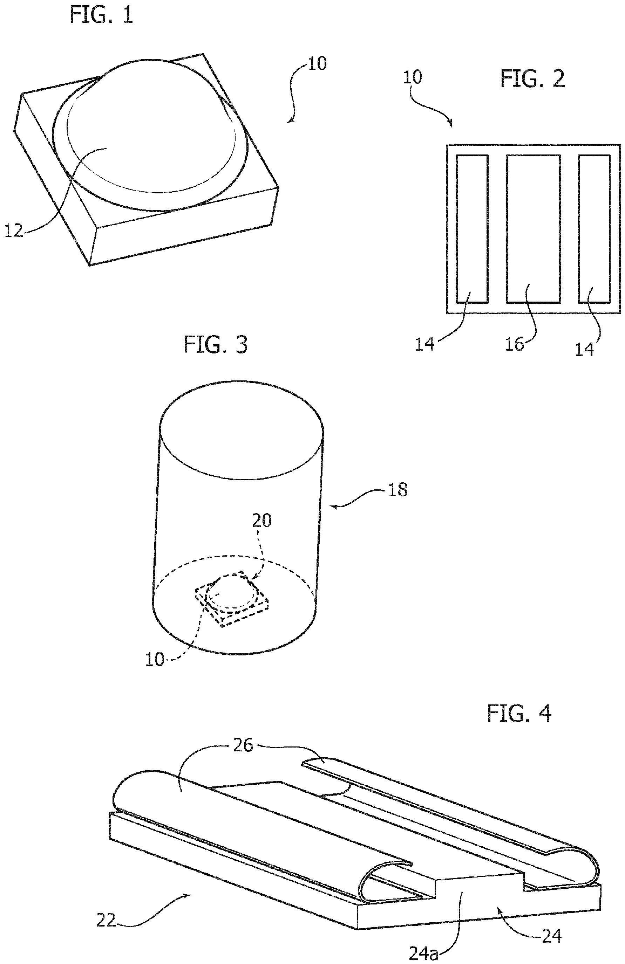

Figure 1 and Figure 2 are two views, from approximately mutually opposite viewpoints, of an electrically powered light radiation source 10, which is adapted to comprise e.g. a solid-state light radiation source such as a LED source.

The view of Figure 1 refers to the front side or face of source 10, from which light is emitted, and which can be provided e.g. with a lens 12.

The view of Figure 2 refers on the contrary to the back side or face of source 10, where two electrical contacts 14 are provided (e.g. respectively anode and cathode, adapted to be implemented as pads), with the optional presence of a thermal pad 16.

Solid-state light radiation sources, e.g. LED engines, of this kind are known, which makes it unnecessary to provide a more detailed description on the subject herein.

Reference 18 in Figure 3 shows a body adapted to act as a support member for light radiation source 10.

To this effect, in one or more embodiments, body 18 may be provided with a cavity 20, in which light radiation source 10 may be arranged by inserting the front side thereof (the side which is visible in Figure 1) into cavity 20. Electrical contacts 14 (and optionally thermal pad 16, the provision whereof is not mandatory) are exposed, i.e. accessible from outside the body 18.

In the Figures, body 18 is shown, in a deliberately simplified way, as a cylindrical body of a material which may be assumed as a light-permeable (i.e. transparent) material, e.g. a plastic material such as PMMA or polycarbonate.

It will be appreciated, however, that the shape of body 18 may be chosen freely; moreover, in one or more embodiments, support member 18 may perform, according to application or use requirements, an optical function, e.g. by exerting a shaping action on the light radiation beam emitted by source 10 from the front side thereof.

In one or more embodiments, moreover, a member 22 may be provided having the function of implementing an electrical contact (and optionally a thermal contact, as will be seen in detail in the following). Member 22 comprises a slug 24 of a thermally dissipative material (e.g. an electrically insulating and thermally conductive plastic material). Member 22 is provided with electrical contact formations 26 (e.g. two formations) adapted to comprise e.g. two flexible metal leaf formations mounted along mutually opposite sides of slug 24.

In one or more embodiments, slug 24 may have a "mesa-like" profile, i.e. with a raised central part 24a on which, as schematically shown in part b), on the right side of Figure 5, a thermally conductive material 28 may be applied, e.g. a pad or a thermally conductive grease paste.

A possible assembling sequence according to one or more embodiments, as exemplified in Figures 5 and following, may comprise arranging light radiation source 10 into cavity 20 (sequence of parts a) and b) of Figure 6), which may be performed in such a way as to implement an interference fitting of source 10 within cavity 20.

In one or more embodiments, the arrangement of source 10 within support member 20 may optionally be strengthened by the application of bonding, e.g. adhesive, layer, adapted to comprise a light-permeable (e.g. transparent) material, which therefore does not affect the propagation of the light radiation emitted by source 10 towards and through support member 18.

Thanks to the wide range of possible shapes of member 18, the mechanical assembling (fixing) of source 10 onto support member 18 enables to arrange the source onto structures (not visible in the Figures) of any kind, e.g. into a lights assembly of a vehicle.

Figures 7 to 10 exemplify possible solutions which may be adopted in order to obtain the electrical and thermal coupling of light source 10.

To this end, contact member 22 may be arranged at the end of the support member 18 in which light radiation source 10 is located (inserted in cavity 20), in such a way as to bring electrical contact formations 26 to rest on contacts or pads 14 provided on the back side of source 10, as schematically shown by the sequence of parts a) and b) of Figure 8.

In one or more embodiments, the electrical contact thus established may be achieved simply thanks to the resilience, e.g. the elasticity, of formations 26 (which may be implemented as spring-like metal leaf formations) without requiring soldering operations.

The sequence of parts a) and b) of Figure 8 exemplifies the possibility of an electrical and/or thermal coupling of source 10 with member 22 (optionally also before inserting source 10 into cavity 20 of body 18), e.g. by making use of the raised central part 24a of slug 24, with the possible provision of thermally conductive electric paste 28.

The electrical contact thus established enables source 10 to be supplied from electrical contacts (not visible in the Figures) connected to member 22.

Similarly, the thermal coupling which may be implemented between source 10 and member 22 enables to dissipate to the outside the heat generated by source 10 in operation, e.g. via member 22 (which may act as a heatsink) and/or a heatsink (not visible in the Figures) on which member 22 is mounted.

Figures 9 and 10 exemplify the possible result of the shown assembling sequence.

Of course, without prejudice to the basic principles, the implementation details and the embodiments may vary, even appreciably, with respect to what has been described herein by way of non-limiting example only, without departing from the extent of protection.

Said extent of protection is defined by the annexed claims.

## Claims

1. A method of assembling lighting devices including an electrically powered light radiation source (10) having:
- a front, light emitting side, and
- a back side with electrical contacts (14) for the light radiation source (10),
the method including:
- providing a support member (18) with a cavity (20) for receiving said light radiation source (10),
- arranging said light radiation source (10) in said cavity (20) of said support member (18) by inserting the front side of the light radiation source (10) into said cavity (20) by leaving said electrical contacts (14) at the backside exposed,
- providing an electrical contact member (22) including resilient electrical contact formations (26), by providing said resilient electrical contact formations (26) as leaf-like formations, and
- establishing electrical contact of said electrical contact formations (26) with said electrical contacts (14) on the back side of said light radiation source (10),
the method **characterized in that** it includes:
- providing said cavity (20) with a shape suited for producing interference fitting with the front light emitting side of the light radiation source (10) inserted in said cavity (20), and
- providing said electrical contact member (22) as a heat sink slug (24) with said leaf-like formations mounted along mutually opposite sides of said slug (24) .

2. The method of claim 1, including using as said support member (18) an optical member to be traversed by light radiation from said light radiation source (10) .

3. The method of any of the previous claims, including providing a light permeable bonding layer, preferably an adhesive layer, between the cavity (20) in said support member (18) and the front, light emitting side of the light radiation source (10) inserted in said cavity (20).

4. The method of any of the previous claims, including providing thermal coupling between said electrical contact member (22) and said light radiation source (10) arranged in said cavity (20) of the support member (18).

5. The method of claim 4, including:
- providing a thermal contact formation (16) at the back side of the light radiation source (10), and
- providing a thermally conductive material (28) between said thermal contact formation (16) and said electrical contact member (22).

6. A lighting device, including:
- an electrically powered light radiation source (10) having a front light emitting side and a back side with electrical contacts (14) for the light radiation source (10),
- a support member (18) with a cavity (20) receiving said light radiation source (10) with said light radiation source (10) arranged in said cavity (20) of said support member (18) with the front side of the light radiation source (10) inserted into said cavity (20) with said electrical contacts (14) exposed,
- an electrical contact member (22) including resilient leaf-like electrical contact formations (26) in electrical contact with said electrical contacts (14) at the back side of said light radiation source (10),
the device **characterized in that** it includes:
- said cavity (20) with a shape suited for producing interference fitting with the front light emitting side of the light radiation source (10) inserted in said cavity (20), and
- said electrical contact member (22) provided as a heat sink slug (24) with said leaf-like formations mounted along mutually opposite sides of said slug (24) .

7. The device of claim 6, wherein electrical contact of said electrical contact formations (26) with said electrical contacts (14) is exempt from soldering.

## Patentansprüche

1. Verfahren zum Zusammenbauen von Leuchtvorrichtungen, die eine elektrisch betriebene Lichtstrahlungsquelle (10) umfassen mit:
- einer vorderen lichtemittierenden Seite, und
- einer Rückseite mit elektrischen Kontakten (14) für die Lichtstrahlungsquelle (10),
wobei das Verfahren umfasst:
- Bereitstellen eines Trägerelements (18) mit einem Hohlraum (20) zum Aufnehmen der Lichtstrahlungsquelle (10),
- Anordnen der Lichtstrahlungsquelle (10) in dem Hohlraum (20) des Trägerelements (18) durch Einfügen der vorderen Seite der Lichtstrahlungsquelle (10) in den Hohlraum (20), wobei die elektrischen Kontakte (14) auf der Rückseite exponiert gelassen werden,
- Bereitstellen eines elektrischen Kontaktelements (22), das elastische elektrische Kontaktformationen (26) umfasst, durch Bereitstellen der elastischen elektrischen Kontaktformationen (26) als blattähnliche Formationen, und
- Aufbauen eines elektrischen Kontakts der elektrischen Kontaktformationen (26) mit den elektrischen Kontakten (14) auf der Rückseite der Lichtstrahlungsquelle (10),
wobei das Verfahren **dadurch gekennzeichnet ist, dass** es umfasst:
- Bereitstellen des Hohlraumes (20) mit einer Form, die geeignet ist, um einen Presssitz mit der vorderen lichtemittierenden Seite der Lichtstrahlungsquelle (10) zu erzeugen, die in dem Hohlraum (20) eingefügt ist, und
- Bereitstellen des elektrischen Kontaktelements (22) als ein Wärmesenkenstutzen (24), wobei die blattähnlichen Formationen längs einander gegenüberliegenden Seiten des Stutzens (24) montiert sind.

2. Verfahren gemäß Anspruch 1, umfassend das Verwenden eines optischen Elements als Trägerelement (18), das durch die Lichtstrahlung von der Lichtstrahlungsquelle (10) durchquert werden soll.

3. Verfahren gemäß einem der vorangehenden Ansprüche, umfassend Bereitstellen einer lichtdurchlässigen Verbindungsschicht, vorzugsweise einer Haftschicht, zwischen dem Hohlraum (20) in dem Trägerelement (18) und der vorderen lichtemittierenden Seite der Lichtstrahlungsquelle (10), die in dem Hohlraum (20) eingefügt ist.

4. Verfahren gemäß einem der vorangehenden Ansprüche, umfassend Bereitstellen einer thermischen Kopplung zwischen dem elektrischen Kontaktelement (22) und der Lichtstrahlungsquelle (10), die in dem Hohlraum (20) des Trägerelements (18) angeordnet ist.

5. Verfahren gemäß Anspruch 4, das aufweist:
- Bereitstellen einer thermischen Kontaktformation (16) an der Rückseite der Lichtstrahlungsquelle (10), und
- Bereitstellen eines thermisch leitenden Materials (28) zwischen der thermischen Kontaktformation (16) und dem elektrischen Kontaktelement (22).

6. Leuchtvorrichtung, die aufweist:
- eine elektrisch betriebene Lichtstrahlungsquelle (10) mit einer vorderen lichtemittierenden Seite und einer Rückseite mit elektrischen Kontakten (14) für die Lichtstrahlungsquelle (10),
- ein Trägerelement (18) mit einem Hohlraum (20), das die Lichtstrahlungsquelle (10) aufnimmt, wobei die Lichtstrahlungsquelle (10) in dem Hohlraum (20) des Trägerelements (18) angeordnet ist, wobei die vordere Seite der Lichtstrahlungsquelle (10) in dem Hohlraum (20) eingefügt ist, wobei die elektrischen Kontakte (14) exponiert sind,
- ein elektrisches Kontaktelement (22), das elastische blattähnliche Kontaktformationen (26) umfasst, die in elektrischem Kontakt mit den elektrischen Kontakten (14) auf der Rückseite der Lichtstrahlungsquelle (10) sind,
wobei die Vorrichtung **dadurch gekennzeichnet ist, dass** sie umfasst:
- den Hohlraum (20) mit einer Form, die geeignet ist, um einen Presssitz mit der vorderen lichtemittierenden Seite der Lichtstrahlungsquelle (10) zu erzeugen, die in den Hohlraum (20) eingefügt ist, und
- wobei das elektrische Kontaktelement (22) als ein Wärmesenkenstutzen (24) bereitgestellt ist, wobei die blattähnlichen Formationen längs einander gegenüberliegenden Seiten des Stutzens (24) montiert sind.

7. Vorrichtung gemäß Anspruch 6, wobei der elektrische Kontakt der elektrischen Kontaktformation (26) mit den elektrischen Kontakten (14) vom Löten ausgenommen ist.

## Revendications

1. Un procédé d'assemblage de dispositifs d'éclairage comprenant une source de rayonnement lumineux alimentée électriquement (10) présentant :
- un côté frontal émetteur de lumière, et
- un côté dorsal avec des contacts électriques (14) pour la source de rayonnement lumineux (10),
le procédé comprenant :
- l'obtention d'un organe support (18) avec une cavité (20) destinée à recevoir ladite source de rayonnement lumineux (10),
- l'agencement de ladite source de rayonnement lumineux (10) dans ladite cavité (20) dudit organe support (18) par insertion du côté frontal de la source de rayonnement lumineux (10) à l'intérieur de ladite cavité (20) en laissant exposés lesdits contacts électriques (14) côté dorsal,
- l'obtention d'un organe de contact électrique (22) comprenant des formations de contact électrique élastiques (26), par obtention desdites formations de contact électrique élastiques (26) sous forme de formations semblables à des feuilles, et
- l'établissement d'un contact électrique desdites formations de contact électrique (26) avec lesdits contacts électriques (14) sur la face dorsale de ladite source de rayonnement lumineux (10),
le procédé étant **caractérisé en ce qu'**il comprend :
- l'obtention de ladite cavité (20) avec une forme telle qu'elle permet de réaliser un ajustement serré avec le côté frontal émetteur de lumière de la source de rayonnement lumineux (10) insérée dans ladite cavité (20), et
- l'obtention dudit organe de contact électrique (22) sous forme d'un barreau de refroidissement thermique (24) avec lesdites formations semblables à des feuilles montées le long de côtés mutuellement opposés dudit barreau (24).

2. Le procédé de la revendication 1, comprenant l'utilisation comme ledit organe support (18) d'un organe optique destiné à être traversé par le rayonnement lumineux provenant de ladite source de rayonnement lumineux (10).

3. Le procédé de l'une des revendications précédentes, comprenant l'obtention d'une couche de liaison perméable à la lumière, de préférence une couche adhésive, entre la cavité (20) dudit organe support (18) et le côté frontal émetteur de lumière de la source de rayonnement lumineux (10) insérée dans ladite cavité (20).

4. Le procédé de l'une des revendications précédentes, comprenant l'obtention d'un couplage thermique entre ledit organe de contact électrique (22) et ladite source de rayonnement lumineux (10) agencée dans ladite cavité (20) de l'organe support (18).

5. Le procédé de la revendication 4, comprenant :
- l'obtention d'une formation de contact thermique (16) au niveau du côté dorsal de la source de rayonnement lumineux (10), et
- l'obtention d'un matériau thermiquement conducteur (28) entre ladite formation de contact thermique (16) et ledit organe de contact électrique (22).

6. Un dispositif d'éclairage, comprenant :
- une source de rayonnement lumineux alimentée électriquement (10) possédant un côté frontal émetteur de lumière et un côté dorsal avec des contacts électriques (14) pour la source de rayonnement lumineux (10),
- un organe support (18) avec une cavité (20) recevant ladite source de rayonnement lumineux (10) avec ladite source de rayonnement lumineux (10) agencée dans ladite cavité (20) dudit organe support (18) avec le côté frontal de la source de rayonnement lumineux (10) inséré à l'intérieur de ladite cavité (20) avec lesdits contacts électriques (14) exposés,
- un organe de contact électrique (22) comprenant des formations de contact électrique semblables à des feuilles (26) en contact électrique avec lesdits contacts électriques (14) sur le côté dorsal de ladite source de rayonnement lumineux (10),
le dispositif étant **caractérisé en ce qu'**il comprend :
- ladite cavité (20) avec une forme qui lui permet de réaliser un ajustement serré avec le côté frontal émetteur de lumière de la source de rayonnement lumineux (10) insérée dans ladite cavité (20), et
- ledit organe de contact électrique (22) obtenu sous forme d'un barreau de refroidissement thermique (24) avec lesdites formations en forme de feuilles montées le long de côtés mutuellement opposés dudit barreau (24) .

7. Le dispositif de la revendication 6, dans lequel le contact électrique desdites formations de contact électrique (26) avec lesdits contacts électriques (14) est dépourvu de soudure.
